Europäisches Patentamt

European Patent Office

Office européen des brevets

(19)

(11) **EP 0 642 027 B1**

(12) **EUROPÄISCHE PATENTSCHRIFT**

(45) Veröffentlichungstag und Bekanntmachung des Hinweises auf die Patenterteilung:
**17.10.2001 Patentblatt 2001/42**

(51) Int Cl.[7]: **G01R 31/06**, G01R 27/18

(21) Anmeldenummer: **94112813.4**

(22) Anmeldetag: **17.08.1994**

(54) **Verfahren und Vorrichtung zur Erfassung von Erdfehlern auf den Leitern einer elektrischen Maschine**

Method and device for detecting earth faults of the conductors in a electrical machine

Procédé et dispositif pour détecter des défauts à la terre des fils conducteurs dans une machine électrique

(84) Benannte Vertragsstaaten:
**AT CH DE FR GB LI SE**

(30) Priorität: **01.09.1993 DE 4329382**

(43) Veröffentlichungstag der Anmeldung:
**08.03.1995 Patentblatt 1995/10**

(73) Patentinhaber: **ABB Power Automation AG**
**5401 Baden (CH)**

(72) Erfinder: **Pfiffner, Michael**
**CH-8906 Bonstetten (CH)**

(74) Vertreter: **ABB Patent Attorneys**
**c/o ABB Business Services Ltd. (SLE-I)**
**Haselstrasse 16/699**
**5401 Baden (CH)**

(56) Entgegenhaltungen:
**EP-A- 0 131 718        EP-A- 0 274 691**
**EP-A- 0 518 785**

## Beschreibung

### Technisches Gebiet

Die Erfindung bezieht sich auf das Gebiet der Schutztechnik.

Sie geht aus von einem Verfahren zur Erfassung von Erdfehlern auf den Leitern einer elektrischen Maschine nach dem Oberbegriff des ersten Anspruchs.

### Stand der Technik

Ein solches Verfahren wird z.B. in der Gerätebeschreibung "100% Stator- und Rotor-Erdschlussschutz für grosse Generatoren GIX 104" der ABB Relays AG, Baden beschrieben. Ein verwandtes Verfahren wird in der Gerätebeschreibung "100%-iger Generator-Statorerdschluss-Schutz GIX 103" der selben Firma beschrieben.

Erdfehler treten in einer elektrischen Maschine, insbesondere in Generatoren grösserer Leistung, hauptsächlich durch mechanische Beschädigung der Isolation zwischen den Leitern und den Eisenteilen auf. Aufgrund solcher Erdfehler fliesst ein Fehlerstrom, dessen Grösse je nach der Art des Fehlers verschiedene Werte annimmt. Nach dem Ohmschen Gesetz kann daraus bei bekannter Spannung ein Fehlerwiderstand ermittelt werden, dessen Grösse zur Beurteilung des Fehlers herangezogen werden kann. Im Normalfall weist der Fehlerwiderstand Werte im Bereich von $M\Omega$ auf, bei Fehlern kann er auf um Grössenordnungen kleinere Werte absinken.

Da der Sternpunkt in den zum Stern geschalteten Leitern z.B. des Stators eines Generators definitionsgemäss spannungslos ist, kann ein Fehler in der Nähe des Sternpunkts nur erfasst werden, wenn die Leiter gegenüber dem Erdpotential verspannt werden. Dies geschieht bei beiden bekannten Schutzeinrichtungen und Verfahren mittels einer niederfrequenten Spannung, welche in die Leiter eingespeist wird.

Im Betrieb fliesst ein kleiner Strom durch die Erdreaktanzen der Leiter gegen Erde. Bei einem Erdfehler werden diese Reaktanzen kurzgeschlossen, und der Strom wird grösser als im erdschlussfreien Betrieb. Beim GIX103 wird ein Injektionssignal verwendet, dessen Phasenlage unverändert bleibt. Nachteilig bei dieser Methode ist jedoch, dass die Möglichkeit besteht, dass ein über die Kapazitäten des Rotorkreises schliessender Strom der gleichen Frequenz wie diejenige der Injektionsspannung auftreten kann. Dadurch kann es zu Fehlanzeigen kommen.

Beim GIX104 versucht man dies zu vermeiden, indem die Phase der Injektionsspannung dauernd zwischen zwei Werten hin- und hergeschaltet wird. Dadurch kann ein Fehlerstrom präzise von anderen Ströme unterschieden werden.

Beiden Schutzeinrichtungen ist gemeinsam, dass der Fehlerwiderstand jedoch nur anhand von Erfahrungswerten, bzw. anhand aufgenommener und für jede Maschine verschiedener Kennlinien nachträglich bestimmt werden kann. Zudem wird die Messung des Fehlerstroms durch Alterung, Temperatur, Schwankungen des Injektionsspannungspegels etc. beeinflusst. Die beiden Systeme weisen zudem die bekannten Unzulänglichkeiten auf, welche analogen Systemen von Haus aus anhaften.

In EP-A-0 131 718 wird eine Detektion eines Erdschlusses einer Rotorwindung durchgeführt, indem die Windung mittels einer Injektionsspannungsquelle gegenüber dem Erdpotential verspannt wird. Ein zwischen dieser Spannungsquelle und der Windung liegender Erdungswiderstand führt zu einer Messspannung, welche durch ein Relais erfasst wird.

EP-A-0 274 691 offenbart ein System zur Detektion von Kurzschlüssen zwischen Rotorwindungen. Das System weist eine arithmetische Einheit zur Bestimmung einer Windungsimpedanz als Quotient zwischen Spannung und Strom der Windung auf.

### Darstellung der Erfindung

Aufgabe der vorliegenden Erfindung ist es deshalb, ein Verfahren und eine Vorrichtung zur Erfassung von Erdfehlern auf den Leitern einer elektrischen Maschine anzugeben, bei welchem die Nachteile der bekannten analogen Verfahren vermieden werden können.

Diese Aufgabe wird bei einem Verfahren der eingangs genannten Art durch die Merkmale des ersten Anspruchs gelöst.

Kern der Erfindung ist also, dass durch eine numerische Auswertung der Messignale orthogonale Komponenten der injizierten und der gemessenen Spannung bestimmt werden und daraus vektoriell ein Erdfehlerwiderstand berechnet wird.

Ein erstes Ausführungsbeispiel zeichnet sich dadurch aus, dass es sich bei den Leitern der elektrischen Maschine um die Statorwicklungen z.B. eines Generators handelt, welche zum Stern geschaltet sind. Das Injektionssignal verspannt den Sternpunkt der Wicklung gegenüber dem Erdpotential. Anhand der gemessenen und der injizierten Spannung kann nun der Fehlerwiderstand berechnet werden. Die Berechnung wird besonders einfach, wenn sie in einem mit der Injektionsfrequenz rotierenden Koordinatensystem vorgenommen wird.

Ein zweites Ausführungsbeispiel zeichnet sich dadurch aus, dass es sich bei den Leitern um die Rotorwicklungen z.B. eines Generators handelt. Die Injektionsspannung wird in diesem Fall über zwei Koppelkapazitäten in die Leiter eingespeist.

Zu diesen beiden Ausführungsbeispielen wird zudem je eine Vorrichtung zur Durchführung des Verfahren angegeben. Zur Injektion und zur Messung ist je ein Wandler vorgesehen. Das Injektionssignal wird über einen Koppelwiderstand und im Falle des Rotors zusätzlich über Koppelkondensatoren in die Leiter eingespeist. Die Messung erfolgt über einem Referenzwiderstand mittels eines Messwandlers. Für die Auswertung ist schliesslich eine numerische Auswerteeinheit vorgesehen. In dieser Auswerteeinheit wird die Berechnung des Fehlerwiderstands nach den angegebenen Formeln ausgeführt.

Weitere Ausführungsbeispiele ergeben sich aus den Unteransprüchen.

Der Vorteil des erfindungsgemässen Aufbaus besteht insbesondere darin, dass der Fehlerwiderstand aus der gemessenen und der injizierten Spannung direkt berechnet werden kann. Kennlinien müssen keine mehr bestimmt werden, und der berechnete Wert ist unabhängig von der Erdreaktanz bzw. der Amplitude des Injektionssignals.

## Kurze Beschreibung der Zeichnungen

Nachfolgend wird die Erfindung anhand von Ausführungsbeispielen im Zusammenhang mit den Zeichnungen näher erläutert.

Es zeigen:

**Fig. 1a,b,c,d**      Die prinzipielle Schaltungsanordnung für eine Erdfehler-Erfassung am Stator (a) bzw. Rotor (b) einer Drehstrommaschine;

**Fig. 2a,b**      Das Zeigerdiagramm der Ströme und Spannungen beim Stator; und

**Fig. 3a,b**      Die Ersatzschaltbilder bei einem Erdfehler im Stator (a) bzw. Rotor (b).

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

## Wege zur Ausführung der Erfindung

Im folgenden wird das erfindungsgemässe Verfahren und die Vorrichtung beispielhaft anhand einer Drehstrommaschine, insbesondere eines Generators erläutert. Die Erfindung ist jedoch nicht auf Generatoren beschränkt, sondern kann für elektrische Maschinen im allgemeinen, so z.B. auch für Transformatoren verwendet werden.

**Figur 1a** zeigt die prinzipielle Schaltungsanordnung zur Erfassung von Erdfehler auf den Statorwicklungen (R,S,T) einer Drehstrommaschine. Die Statorwicklungen sind zum Stern geschaltet und werden über einen Erdungswiderstand (RE) mit dem Parallelwiderstand (Rp) geerdet. Damit Erdfehler auf der gesamten Wicklung erfasst werden können, wird der Sternpunkt der Wicklung mittels eines Injektionssignals (Ui) verspannt. Dieses Injektionssignal (Ui) wird in einer Injektionssignalquelle (4) generiert und über einen Injektionswandler (5) und einen Erdungswiderstand (RE) in den Sternpunkt (2) eingespeist. Zur Erfassung der Erdfehler wird über einem Erdungswiderstand (RE) die Spannung (URE) gemessen und über einen Messwandler (6) einer Auswerteeinheit (7) zugeführt. In der Auswerteeinheit (7) wird anhand der injizierten (Ui) und der gemessenen Spannung (URE) der Fehlerwiderstand (Rf) berechnet.

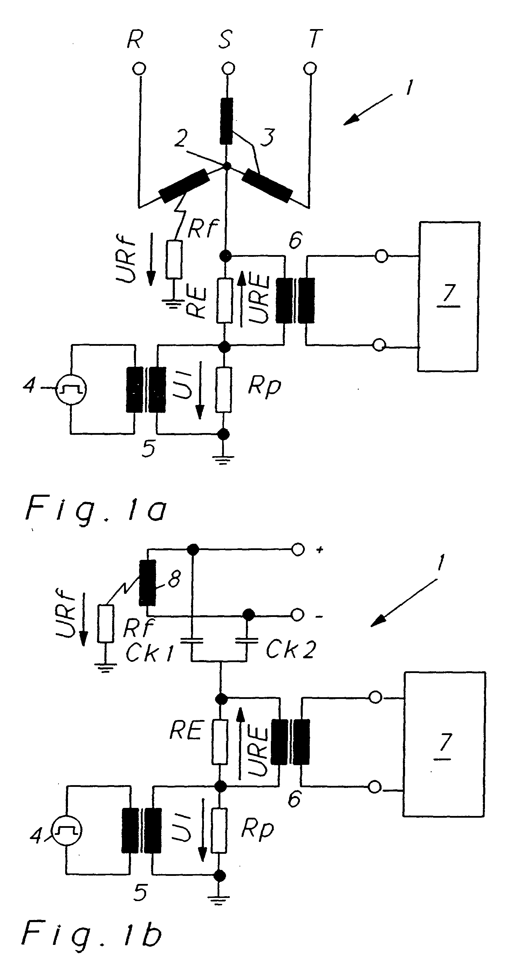

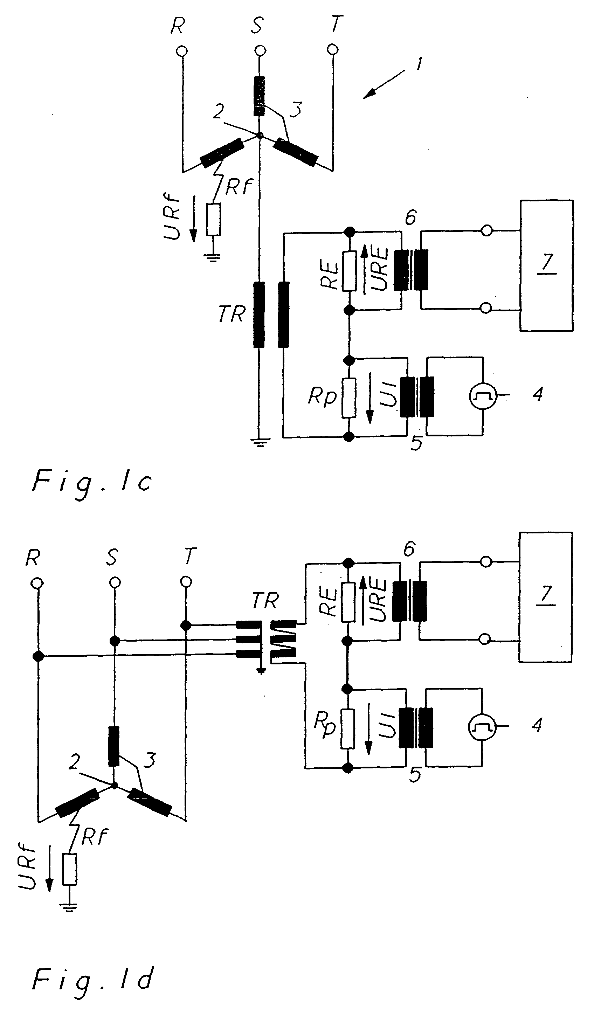

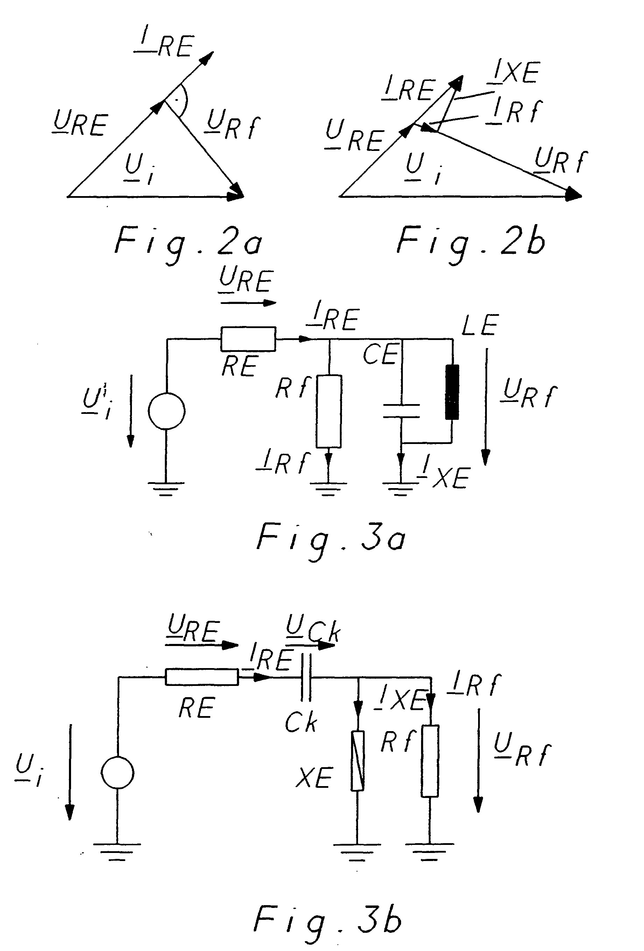

**Figur 3a** zeigt das Ersatzschaltbild der Schaltungsanordnung nach Figur 1. Die Injektionsspannung (Ui) wird als ideale Spannungsquelle dargestellt. Zwischen dem Fehlerwiderstand (Rf) und der Erdreaktanz (XE) des Stators ist der Referenzwiderstand (RE) vorhanden. Die Erdreaktanz wird aus einer Parallelschaltung einer Erdkapazität (CE) und einer Erdinduktivität (LE) gebildet. Im Normalfall weist der Fehlerwiderstand einen unendlich hohen Wert auf. Durch mechanische Fehler kann er jedoch absinken und somit Strom führen.

Die dazugehörigen Zeigerdiagramme sind in den **Figur 2a,b** dargestellt. Den nachfolgenden Ausführungen liegt eine vektorielle Betrachtungsweise in einem mit der Frequenz (f1) des Injektionssignals rotierenden Koordinatensystem zugrunde. Das heisst, es wird nur die erste Harmonische des Spektrums des Injektionssignals (Ui) betrachtet. Unterstrichene Variable bedeuten im folgenden stets Vektoren, welche mit der Frequenz (f1) rotieren.

Im Normalfall (Figur 2a) fliesst durch den Fehlerwiderstand kein Strom, so dass der Strom durch die Erdreaktanz ($\underline{I}$XE) genau rechtwinklig auf die entsprechende Spannung ($\underline{U}$Rf) steht. Im Falle eines Erdfehlers ist der Strom durch den Fehlerwiderstand (Rf) nicht mehr Null. Dadurch setzt sich der Gesamtstrom ($\underline{I}$RE) aus einem reaktiven ($\underline{I}$XE) und einem ohmschen ($\underline{I}$Rf) Teil zusammen und die Spannung ($\underline{U}$Rf) ändert sich dementsprechend. Es gilt nach Kirchhoff:

$$\underline{U}_{R_f} = \underline{U}_i - \underline{U}_{R_E}$$

Der Strom (IRE), welcher durch Rf und CE gegen Erde fliesst ist proportional zur Spannung URE:

$$\underline{I}_{RE} = \frac{\underline{U}_{RE}}{R_E}$$

Dieser Strom kann in zwei orthogonale Komponenten IRf und IXE aufgeteilt werden. IRf ist dabei parallel zu URf. Deshalb kann der Betrag von IRf, d.h. IRf als Skalarprodukt des Stromes IRE und des Einheitsvektors in Richtung von URf berechnet werden:

$$I_{R_f} = \frac{\underline{I}_{R_E} * \underline{U}_{R_f}}{U_{R_f}} \quad * = \text{Skalarprodukt}$$

damit wird:

$$R_f = \frac{U_{R_f}}{I_{R_f}} = \frac{U_{R_f}^2}{\left(\underline{I}_{R_f} * \underline{U}_{R_f}\right)} \simeq R_E \frac{\left(\underline{U}_i - \underline{U}_{R_E}\right)^2}{\underline{U}_i * \underline{U}_{R_E} - U_{R_E}^2}$$

bzw in Komponenten:

$$R_f = R_E \cdot \frac{\left(U_{ix} - U_{REx}\right)^2 + \left(U_{iy} - U_{REy}\right)^2}{U_{ix} \cdot U_{REx} + U_{iy} \cdot U_{REy} - \left(U_{REx}^2 + U_{REy}^2\right)}$$

Wie man aus der Formel leicht sieht, ist der Fehlerwiderstand unabhängig von der Erdreaktanz und hängt nur von der injizierten Spannung (Ui) und der gemessenen Spannung (URE) ab. Damit ist es nicht mehr nötig, für jede Maschine eine separate Kennlinie aufzunehmen. Vielmehr kann obige Formel als Algorithmus für die Berechnung des Fehlerwiderstands verwendet werden. Es ist jedoch zu beachten, dass dieses Messprinzip nur funktioniert, wenn die Injektionsspannung die einzige Quelle mit der Frequenz fl ist. Deshalb wird das System während Injektionspausen laufend auf störende f1-Anteile getestet. Überschreiten die f1-Anteile einen bestimmten Wert, so wird die vorherige Berechnung des Fehlerwiderstandes verworfen.

Beim Rotor sind die Verhältnisse nicht wesentlich anders. Es kommen nur unter Umständen zwei Koppelkondensatoren (Ck1, Ck2) hinzu. **Figur 1b** zeigt das entsprechende Schaltbild. Als Ersatzschaltbild ergibt sich die Anordnung, wie sie in **Figur 3b** dargestellt ist.

Zur Berechnung des Fehlerwiderstand kann genau gleich wie beim Stator vorgegangen werden, nur muss die Spannung URE gemäss dem Ersatzschaltbild im Zähler durch (URE + UCK) ersetzt werden:

$$R_f = R_E \cdot \frac{\left(U_{ix} - U_{REx} - U_{CKx}\right)^2 + \left(U_{iy} - U_{REy} - U_{CKy}\right)^2}{U_{ix} \cdot U_{REx} + U_{iy} \cdot U_{REy} - \left(U_{REx}^2 + U_{REy}^2\right)}$$

Als Injektionssignal (Ui) wird vorzugsweise eine periodische Rechteckschwingung verwendet. Falls das Injektionssignal (Ui) zudem zyklisch unterbrochen wird und Pausen von einigen Perioden eingelegt werden, so kann vermieden werden, dass transiente Vorgänge ein irrtümliches Auslösen verursachen.

Somit umfasst das erfindungsgemässe Verfahren folgende Schritte:

- Injektion der Spannung Ui,
- Messung der Spannung URE, beim Rotor zusätzlich UCk

- Aufteilung der injizierten und gemessenen Spannungen ($\underline{U}i$ und $\underline{URE}$, $\underline{UCk}$) in orthogonale Komponenten (Uix, Uiy bzw. UREx, UREy, ev. UCkx, UCky),
- Berechnung des Fehlerwiderstandes gemäss:

$$R_f = R_E \cdot \frac{\left(U_{ix} - U_{REx}\right)^2 + \left(U_{iy} - U_{REy}\right)^2}{U_{ix} \cdot U_{REx} + U_{iy} \cdot U_{REy} - \left(U_{REx}^2 + U_{REy}^2\right)}$$

bzw.

$$R_f = R_E \cdot \frac{\left(U_{ix} - U_{REx} - U_{Ckx}\right)^2 + \left(U_{iy} - U_{REy} - U_{Cky}\right)^2}{U_{ix} \cdot U_{REx} + U_{iy} \cdot U_{REy} - \left(U_{REx}^2 + U_{REy}^2\right)}$$

Die Vorrichtungen zur Durchführung des Verfahren weisen eine Injektionssignalquelle (4) auf, welche z.B. über einen Injektionswandler (5), einen Parallelwiderstand (Rp) und einen Erdungswiderstand (RE) einerseits mit dem Sternpunkt (2) der Statorwicklungen und andererseits mit den Koppelkondensatoren (Ck1, Ck2) der Rotorwicklung verbunden ist. Über diese Anordnung wird das Injektionssignal (Ui) in die Leiter eingespeist. Parallel zum Erdungswiderstand (RE) ist zudem ein Messwandler (6) vorgesehen. Dessen Ausgang ist mit der Auswerteeinheit (7) verbunden. In der Auswerteeinheit (7) wird periodisch überprüft, ob ein Erdfehler vorhanden ist oder nicht. Dies geschieht dadurch, dass der Fehlerwiderstand (Rf) anhand obiger Formeln berechnet wird. Falls der Fehlerwiderstand eine bestimmte, frei einstellbare Schwelle unterschreitet, wird unverzüglich ein Alarmsignal aktiviert.

Das Verfahren kann aber auch für andere Arten der Einspeisung des Injektionssignals verwendet werden. So z.B. auch für die sogenannten sekundären Injektionsverfahren, wo die Erdungs- bzw. Parallelwiderstände über einen Transformator mit dem Sternpunkt verbunden werden **(Figur 1c)**. Eine weitere Variante **(Figur 1d)** zeichnet sich dadurch aus, dass das Injektionssignal über einen mehrphasigen Transformator direkt in die Leiter eingespeist wird. Diese Variante wird insbesondere bei Maschinen verwendet, bei welchen der Sternpunkt nicht zugänglich ist.

Insgesamt steht also mit der Erfindung ein Verfahren zur Erdfehlererfassung zur Verfügung, bei welchem der Fehlerwiderstand laufend berechnet und direkt angezeigt werden kann, ohne dass eigens gemessene Kurven herangezogen werden müssen. Zudem ist die Fehlerwiderstandsberechnung unabhängig von der Erdreaktanz, der Höhe des Injektionspegels und allfälligen Alterungseffekten.

Mit dem erfindungsgemässen Verfahren erhält man somit einen zuverlässigeren und präziseren Erdfehlerschutz.

**Bezeichnungsliste**

| | |
|---|---|
| 1 | Stator |
| 2 | Sternpunkt |
| 3 | Statorwicklungen |
| 4 | Injektionssignalquelle |
| 5 | Injektionswandler |
| 6 | Messwandler |
| 7 | Auswerteeinheit |
| 8 | Rotorwicklung |
| | |
| R, S, T | Statorklemmen |
| +, - | Rotorklemmen |
| Rf | Fehlerwiderstand |
| RE | Erdungswiderstand |
| Rp | Parallelwiderstand |
| CE | Erdkapazität |

| LE | Erdinduktivität |
|---|---|
| XE | Erdreaktanz |
| Ck1, Ck2 | Koppelkapazitäten |
| TR | Erdungstransformator |
| Ui | Injektionsspannung |
| URE | Messspannung |
| Uix, Uiy | orthogonale Komponenten von Ui |
| UREx, UREy | orthogonale Komponenten von URE |
| URf | Spannung an Rf |
| UCk | Spannung an Ck1 und Ck2 |
| IRE | Strom durch RE |
| IRf | Strom durch Rf |
| IXE | Strom durch XE |
| f1 | Frequenz des Injektionssignals |

**Patentansprüche**

**1.** Verfahren zur Erfassung von Erdfehlern auf den Leitern einer elektrischen Maschine, bei welchem Verfahren
a) die Leiter mittels eines niederfrequenten Injektionsspannungssignals (Ui) der Frequenz fl gegenüber dem Erdpotential verspannt werden und über einem mit den Leitern verbundenen Erdungswiderstand (RE) eine Messsignalspannung (URE) gemessen und ausgewertet wird;
**dadurch gekennzeichnet, dass**

b) in einer mit dem Messsignal (URE) verbundenen numerischen Auswerteeinheit (7) orthogonale Komponenten (Uix, Uiy, UREx, UREy) der injizierten Spannung (Ui) und der gemessenen Spannung (URE) berechnet werden, und
c) aus diesen orthogonalen Komponenten numerisch ein Erdfehlerwiderstand (Rf) berechnet wird.

**2.** Verfahren nach Anspruch 1, **dadurch gekennzeichnet, dass** es sich bei den Leitern um die zum Stern geschalteten Statorwicklungen (R,S,T) handelt, und das Verfahren die Schritte umfasst:

a) Injektion der Spannung $\underline{U}i$,
b) Messung der Spannung $\underline{U}RE$,
c) Aufteilung der injizierten und gemessenen Spannungen ($\underline{U}i$ und $\underline{U}RE$) in die orthogonalen Komponenten (Uix, Uiy bzw. UREx, UREy) in der Auswerteeinheit (7),
d) Berechnung des Fehlerwiderstandes in der Auswerteeinheit (7) gemäss:

$$R_f = RE \cdot \frac{(U_{ix} - U_{REx})^2 + (U_{iy} - U_{REy})^2}{U_{ix} \cdot U_{REx} + U_{iy} \cdot U_{REy} - (U_{REx}^2 + U_{REy}^2)}$$

**3.** Verfahren nach Anspruch 1, **dadurch gekennzeichnet, dass** es sich bei den Leitern um Rotorwicklungen (8) handelt, in deren Klemmen (+,-) das Injektionssignal (Ui) über Koppelkapazitäten (Ck1, Ck2) eingespeist wird, und das Verfahren die Schritte umfasst:

a) Injektion der Spannung $\underline{U}i$,
b) Messung der Spannung $\underline{U}RE$ und der Spannung $\underline{U}Ck$ über den Koppelkapazitäten (Ck1, Ck2),
c) Aufteilung der injizierten und gemessenen Spannungen ($\underline{U}i$, $\underline{U}RE$ und $\underline{U}Ck$) in orthogonale Komponenten (Uix, Uiy, UREx, UREy, UCkx, UCky) in der Auswerteeinheit (7),
d) Berechnung des Fehlerwiderstandes in der Auswerteeinheit (7) gemäss:

$$R_f = R_E \cdot \frac{\left(U_{ix} - U_{REx} - U_{Ckx}\right)^2 + \left(U_{iy} - U_{REy} - U_{Cky}\right)^2}{U_{ix} \cdot U_{REx} + U_{iy} \cdot U_{REy} - \left(U_{REx}^2 + U_{REy}^2\right)}$$

**4.** Vorrichtung zur Durchführung des Verfahrens nach Anspruch 2, **dadurch gekennzeichnet, dass**

a) das Injektionssignal von einer Injektionssignalquelle (4) über einen Injektionswandler (5), einen Parallelwiderstand (Rp) und den Erdungswiderstand (RE) in den Sternpunkt (2) eingespeist wird;
b) parallel zum Erdungswiderstand (RE) ein Messwandler (6) vorgesehen ist, dessen Ausgang mit dem Eingang der Auswerteeinheit (7) verbunden ist.

**5.** Vorrichtung nach Anspruch 4, **dadurch gekennzeichnet, dass** der Erdungswiderstand (RE) und der Parallelwiderstand (Rp) über einen Erdungstransformator (TR) mit dem Sternpunkt (2) verbunden sind.

**6.** Vorrichtung zur Durchführung des Verfahrens nach Anspruch 2, **dadurch gekennzeichnet, dass**

a) das Injektionssignal von einer Injektionssignalquelle (4) über einen Injektionswandler (5), einen Parallelwiderstand (Rp), den Erdungswiderstand (RE) und einen Erdungstransformator (TR) in die Leiter eingespeist wird;
b) parallel zum Erdungswiderstand (RE) ein Messwandler (6) vorgesehen ist, dessen Ausgang mit dem Eingang der Auswerteeinheit (7) verbunden ist.

**7.** Vorrichtung zur Durchführung des Verfahrens nach Anspruch 3, **dadurch gekennzeichnet, dass**

a) das Injektionssignal von einer Injektionssignalquelle (4) über einen Injektionswandler (5), einen Parallelwiderstand (Rp), den Erdungswiderstand (RE) und zwei Koppelkondensatoren (Ck1, Ck2) in die Rotorklemmen (+,-) eingespeist wird;
b) parallel zum Erdungswiderstand (RE) ein Messwandler (6) vorgesehen ist, dessen Ausgang mit dem Eingang der Auswerteeinheit (7) verbunden ist.

**Claims**

**1.** Method for detecting earth faults on the conductors of an electrical machine, in which method

a) the conductors are biased with respect to the earth potential by means of a low-frequency injection voltage signal (Ui) of frequency fl, and a measuring signal voltage (URE) is measured and evaluated via a earthing resistor (RE) connected to the conductors; **characterized in that**
b) orthogonal components (Uix, Uiy, UREx, UREy) of the injected voltage (Ui) and the measured voltage (URE) are calculated in a numerical evaluation unit (7) connected to the measuring signal (URE), and
c) an earth fault resistance (Rf) is calculated numerically from these orthogonal components.

**2.** Method according to Claim 1, **characterized in that** the conductors are the stator windings (R,S,T) connected in star, and the method comprises the steps:

a) Injection of a voltage Ui,
b) Measurement of the voltage URE,
c) Division of the injected and measured voltages (Ui and URE) into the orthogonal components (Uix, Uiy and UREx, UREy, respectively) in the evaluation unit (7), and
d) Calculation of the fault resistance in the evaluation unit (7) in accordance with:

$$R_f \;=\; RE \;\cdot\; \frac{(U_{ix} - U_{REx})^2 + (U_{iy} - U_{REy})^2}{U_{ix} \cdot U_{REx} + U_{iy} \cdot U_{REy} - (U_{REx}^{\;2} + U_{REy}^{\;2})}$$

**3.** Method according to Claim 1, **characterized in that** the conductors are rotor windings (8) into whose terminals (+,-) the injection signal (Ui) is fed via coupling capacitors (Ck1, Ck2), and the method comprises the steps:

    a) Injection of the voltage $\underline{U}i$,
    b) Measurement of the voltage $\underline{U}RE$ and of the voltage $\underline{U}Ck$ via the coupling capacitors (Ck1, Ck2),
    c) Division of the injected and measured voltages ($\underline{U}i$, $\underline{U}RE$ and $\underline{U}Ck$) into orthogonal components (Uix, Uiy, UREx, UREy, UCkx, UCky) in the evaluation unit (7), and
    d) Calculation of the fault resistance in the evaluation unit (7) in accordance with:

$$R_f \;=\; RE \;\cdot\; \frac{(U_{ix} - U_{REx} - U_{CEx})^2 + (U_{iy} - U_{REy} - U_{CEy})^2}{U_{ix} \cdot U_{REx} + U_{iy} \cdot U_{REy} - (U_{REx}^{\;2} + U_{REy}^{\;2})}$$

**4.** Device for carrying out the method according to claim 2, **characterized in that**

    a) the injection signal is fed into the star point (2) from an injection signal source (4) via an injection transformer (5), a parallel resistor (Rp) and the earthing resistor (RE); and
    b) a measuring transformer (6), whose output is connected to the input of the evaluation unit (7), is provided in parallel with the earthing resistor (RE) .

**5.** Device according to Claim 4, **characterized in that** the earthing resistor (RE) and the parallel resistor (Rp) are connected to the star point (2) via a earthing transformer (TR).

**6.** Device for carrying out the method according to Claim 2, **characterized in that**

    a) the injection signal is fed into the conductors from an injection signal source (4) via an injection transformer (5), a parallel resistor (Rp), the earthing resistor (RE) and a earthing transformer (TR); and
    b) a measuring transformer (6), whose output is connected to the input of the evaluation unit (7), is provided in parallel with the earthing resistor (RE).

**7.** Device for carrying out the method according to Claim 3, **characterized in that**

    a) the injection signal is fed into the rotor terminals (+,-) from an injection signal source (4) via an injection transformer (5), a parallel resistor (Rp), the earthing resistor (RE) and two coupling capacitors (Ck1, Ck2); and
    b) a measuring transformer (6), whose output is connected to the input of the evaluation unit (7), is provided in parallel with the earthing resistor (RE) .

**Revendications**

**1.** Procédé de détection des défauts d'isolation par rapport à la terre des conducteurs d'une machine électrique, dans lequel :

    a) les conducteurs sont placés sous tension par rapport au potentiel de terre au moyen d'un signal de tension d'injection (Ui) à basse fréquence, de fréquence f1, et une tension de signal de mesure (URE) est mesurée et évaluée par l'intermédiaire d'une résistance d'isolation par rapport à la terre (RE) reliée aux conducteurs, **caractérisé en ce que**
    b) les composantes orthogonales (Uix, Uiy, UREx, UREy) de la tension injectée (Ui) et de la tension mesurée (URE) sont calculées dans une unité numérique d'évaluation (7) reliée au signal de mesure (URE), et
    c) une résistance de défaut d'isolation par rapport à la terre (Rf) est calculée numériquement à partir de ces composantes orthogonales.

2. Procédé selon la revendication 1, **caractérisé en ce que** les conducteurs sont les enroulements de stator (R, S, T) branchés en étoile, et le procédé comprend les étapes consistant à :

a) injecter la tension Ui,
b) mesurer la tension URE,
c) diviser la tension injectée et la tension mesurée (Ui et URE) en les composantes orthogonales (Uix, Uiy et UREx, UREy) dans l'unité d'évaluation (7);
d) calculer la résistance de défaut dans l'unité d'évaluation (7) par :

$$R_f = R_E \cdot \frac{\left(U_{ix} - U_{REx}\right)^2 + \left(U_{iy} - U_{REy}\right)^2}{U_{ix} \cdot U_{REx} + U_{iy} \cdot U_{REy} - \left(U_{REx}^2 + U_{REy}^2\right)}$$

3. Procédé selon la revendication 1, **caractérisé en ce que** les conducteurs sont les enroulements du rotor (8), le signal d'injection (Ui) étant appliqué sur ses bornes (+, -) par l'intermédiaire de capacités de couplage (Ck1, Ck2), et le procédé comprend les étapes consistant à :

a) injecter la tension Ui,
b) mesurer la tension URE et la tension UCk aux bornes des capacités de couplage (Ck1, Ck2),
c) diviser la tension injectée et la tension mesurée (Ui, URE et UCk) en les composantes orthogonales (Uix, Uiy, UREx, UREy, UCkx, UCky) dans l'unité d'évaluation (7),
d) calculer la résistance de défaut dans l'unité d'évaluation (7) par :

$$R_f = R_E \cdot \frac{\left(U_{ix} - U_{REx} - U_{Ckx}\right)^2 + \left(U_{iy} - U_{REy} - U_{Cky}\right)^2}{U_{ix} \cdot U_{REx} + U_{iy} \cdot U_{REy} - \left(U_{REx}^2 + U_{REy}^2\right)}$$

4. Dispositif en vue de la mise en oeuvre du procédé selon la revendication 2, **caractérisé en ce que** :

a) le signal d'injection est appliqué au centre (2) de l'étoile par une source (4) de signal d'injection par l'intermédiaire d'un convertisseur d'injection (5), d'une résistance parallèle (Rp) et de la résistance d'isolation par rapport à la terre (RE),
b) un convertisseur (6) dont la sortie est reliée à l'entrée de l'unité d'évaluation (7) est prévue en parallèle sur la résistance d'isolation par rapport à la terre (RE).

5. Dispositif selon la revendication 4, **caractérisé en ce que** la résistance d'isolation par rapport à la terre (RE) et la résistance parallèle (Rp) sont reliées au centre (2) de l'étoile par un transformateur d'isolation par rapport à la terre (TR).

6. Dispositif en vue de la mise en oeuvre du procédé selon la revendication 2, **caractérisé en ce que** :

a) le signal d'injection est appliqué dans le conducteur par une source (4) de signal d'injection par l'intermédiaire d'un convertisseur d'injection (5), d'une résistance parallèle (Rp), de la résistance d'isolation par rapport à la terre (RE) et d'un transformateur d'isolation par rapport à la terre (TR);
b) un convertisseur de mesure (6) dont la sortie est reliée à l'entrée de l'unité d'évaluation (7) est prévu en parallèle sur la résistance d'isolation par rapport à la terre (RE).

7. Dispositif en vue de la mise en oeuvre du procédé selon la revendication 3, **caractérisé en ce que** :

a) le signal d'injection est appliqué aux bornes (+, -) du rotor par une source (4) de signal d'injection par l'intermédiaire d'un convertisseur d'injection (5), d'une résistance parallèle (Rp), de la résistance d'isolation par rapport à la terre (RE) et de deux condensateurs de couplage (Ck1, Ck2);

b) un convertisseur de mesure (6), dont la sortie est reliée à l'entrée de l'unité d'évaluation (7), est prévu en parallèle sur la résistance d'isolation par rapport à la terre (RE).

Fig. 1a

Fig. 1b

11

Fig. 1c

Fig. 1d

Fig. 2a

Fig. 2b

Fig. 3a

Fig. 3b